# EUROPÄISCHE PATENTANMELDUNG

(11) **EP 4 253 977 A1**
(43) Veröffentlichungstag der Anmeldung: **04.10.2023**
(21) Anmeldenummer: 22165925.3
(22) Anmeldetag: 31.03.2022
(51) Int. Cl.: G01R 33/28, G01R 33/56

(54) **MAGNETRESONANZTOMOGRAPH ZUR SCHNELLEN PASSIVEN 3-D INSTRUMENTEN-LOKALISIERUNG UND VERFAHREN ZUM BETRIEB**

(71) Anmelder: Siemens Healthcare GmbH, 91052 Erlangen (DE)
(72) Erfinder: Faust, Jonas, 71229 Leonberg (DE); Maier, Florian, 91054 Buckenhof (DE); Polak, Daniel, 91052 Erlangen (DE); Krafft, Axel Joachim, 91334 Hemhofen (DE)

(57) **Zusammenfassung**

Die Erfindung betrifft ein System aus einem Magnetresonanztomographen und einer Steuerung zur 3D-Lokalisierung eines Instruments mittels eines Magnetresonanztomographen sowie ein Verfahren zum Betrieb des Systems. In einem Schritt des Verfahrens werden Magnetresonanzdaten für eine Abbildung mit einer suszeptibilitätsbasierten, positiven Kontrastmethode in unmittelbarer Umgebung des Instruments mit dem Magnetresonanztomographen erfasst, wobei die Abtastung des k-Raums eine Unterabtastung ist. In einem weiteren Schritt des Verfahrens wird eine Orientierung und/oder Position des Instruments mit der Steuerung ermittelt und die Position und/oder Orientierung des Instruments an einen Benutzer ausgegeben.

## Beschreibung

Die Erfindung betrifft einen Magnetresonanztomographen und ein Verfahren, um ein Instrument in einem Patienten lokalisieren und verfolgen zu können.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Empfangsantennen, sogenannte Lokalspulen verwendet, die zur Erzielung eines besseren Signal-Rauschabstandes unmittelbar am Untersuchungsobjekt angeordnet werden.

Auf vorteilhafte Weise erlaubt ein Magnetresonanztomograph eine Visualisierung des Körperinneren über längere Zeit, ohne den Patienten oder Operateur einer erhöhten Dosis ionisierender Strahlung auszusetzen. Die Magnetresonanztomographie ist wegen der komplexen Bilderfassung und damit langsamen Bildfolge nur schwierig zur Echtzeitüberwachung zu nutzen. Darüber hinaus sind Instrumente in Echtzeit darzustellen, die selbst nicht nur kein Magnetresonanzsignal erzeugen, sondern viel mehr durch ihre metallischen Eigenschaften die Erfassung in der Umgebung des Instruments verhindern.

Es ist daher eine Aufgabe der vorliegenden Erfindung, ein System mit einem Magnetresonanztomographen bereitzustellen, das eine schnelle Verfolgung eines Instruments erlaubt.

Diese Aufgabe wird durch ein System nach Anspruch 1 und ein Verfahren nach Anspruch 7 sowie ein Verfahren zum Training eines neuronalen Netzwerkes nach Anspruch 13 gelöst.

Das erfindungsgemäße System weist einen Magnetresonanztomographen und eine Steuerung auf. Die Steuerung kann dabei die Steuerung sein, die in dem Magnetresonanztomographen die Erfassung von Magnetresonanzdaten steuert. Die Steuerung kann aber auch eine dedizierte Steuerung zur Bildrekonstruktion sein. Es ist denkbar, dass sich die Steuerung am gleichen Ort wie der Magnetresonanztomograph befindet oder aber auch abgesetzt und über eine Datenverbindung, beispielsweise ein Datennetzwerk, mit dem Magnetresonanztomographen verbunden ist. Auch eine Implementierung der Steuerung als Cloud-Ressource ist möglich.

Im Folgenden sind die Begriffe Abbildung und Bildrekonstruktion nicht auf eine vollständige und dem abgebildeten Gegenstand nach den Sehgewohnheiten des menschlichen Beobachters beschränkte Darstellung beschränkt, sondern beschreiben hierbei eine Transformation der Magnetresonanzdaten aus dem k-Raum in den Bildraum. Damit ist insbesondere auch eine Rekonstruktion von unterabgetasteten k-Raum Daten gemeint, wobei die nicht erfassten Lücken im k-Raum entweder mit Nullen gefüllt werden (zero-filling). Alternativ kann auch eine iterative Bildrekonstruktion durchgeführt werden, wobei die Rekonstruktion mit einem Regularisierer stabilisiert werden kann (z.B. total variation constraint).

Der Magnetresonanztomograph ist ausgelegt, Magnetresonanzdaten für eine Abbildung mit einer suszeptibilitaetsbasierten, positiven Kontrastmethode in unmittelbarer Umgebung des Instruments zu erfassen. Darunter ist zu verstehen, dass die Eigenschaften des metallischen Instruments, insbesondere die Suszeptibilität, dazu genutzt werden, einen positiven Kontrast, d.h. ein Magnetresonanzsignal in der unmittelbaren Umgebung des Instruments zu erzeugen, während durch geeignete Mittel wie beispielsweise Gradient oder Anregungspuls die Magnetresonanzsignale in einem größeren Abstand zu dem Instrument unterdrückt bzw. reduziert werden. Als größerer Abstand ist dabei ein Abstand größer als 1 mm, 3 mm oder 5 mm anzusehen. Ein Unterdrücken oder Reduzieren kann dabei auch bedeuten, dass die jeweiligen Magnetresonanzsignale in größerem Abstand von dem Instrument so in der Frequenz oder Phase verändert werden, dass sie von dem Magnetresonanztomographen nicht mehr als Magnetresonanzsignal empfangen bzw. interpretiert werden können.

Beispielsweise kann dies durch Verwendung eines Rephasierungs-Gradienten, auch als White Marker-Gradient bezeichnet, erreicht werden, der die durch die Suszeptibilität des Instruments verursachte Dephasierung der Spins kompensiert, während er gleichzeitig in weiterem Abstande die Spins dephasiert. Denkbar wäre aber auch ein Marker an dem Instrument zur Erzeugung eines positiven Kontrasts. Dabei ist die Bezeichnung positiver Kontrast bzw. White Marker nicht auf visuelle Darstellung mit größeren Helligkeitswerten beschränkt, sondern lediglich durch das Vorhandensein bzw. auf relativ stärkere Magnetresonanzsignale der erfassten Larmorfrequenz.

Die Abtastung des k-Raums erfolgt in Form einer Unterabtastung. Darunter ist zu verstehen, dass die Abtastung nicht für eine vollständige Abbildung des abgetasteten Raums hinreichend ist. Dabei kann die Abtastung insbesondere inkohärent erfolgen, d.h. die Abtastung muss nicht in einem regelmäßigen Raster im k-Raum folgen, da keine vollständige Abbildung im Bildraum z.B. durch eine 2- oder 3-dimensionale Fouriertransformation erforderlich ist. In einer bevorzugten Ausführungsform handelt es sich bei der inkohärenten Abtastung um eine radiale Abtastung.

Die Steuerung ist weiterhin ausgelegt, mit den Magnetresonanzdaten eine Orientierung und/oder Position des Instruments zu ermitteln. Dies erfolgt auf Basis der erfassten Magnetresonanzdaten unter Annahme bzw. Ausnutzung von verschiedenen Eigenschaften des Instruments wie Form und Geometrie, die das Bestimmen von Orientierung und/oder Position auf eine geringe Anzahl von zu bestimmenden Parametern reduziert. Verschiedene Möglichkeiten dafür sind nachfolgend zu den Unteransprüchen beschrieben.

Die Steuerung ist weiterhin ausgelegt, die ermittelte Position und/oder Orientierung einem Nutzer auszugeben. Denkbar ist beispielsweise ein mit dem Magnetresonanztomographen verbundener Bildschirm, auf dem das Instrument in seiner relativen Position zum Patienten dargestellt wird. Vorzugsweise ist die Steuerung auch ausgelegt, dabei eine Darstellung des Patienten zu überlagern. Beispielsweise kann die Steuerung ausgelegt sein, den Magnetresonanztomographen in gewissen Abstanden mit einer Erfassung von Magnetresonanzdaten zur konventionellen Bildgebung beauftragen, ein Abbild rekonstruieren und dieses im Display gemeinsam mit dem Instrument darzustellen. Denkbar ist auch ein mobiles Display wie ein Tablet-PC, wobei die Steuerung ausgelegt ist, die Abbildung über ein Datennetz an dieses mobile Display zur Ausgabe zu senden.

Auf vorteilhafte Weise erlauben die Unterabtastung und die Reduzierung des Instruments auf wenige charakterisierende Parameter eine schnelle Abtastung und damit eine Darstellung in Echtzeit.

Das erfindungsgemäße Verfahren nutzt das erfindungsgemäße System zur 3D-Lokalisierung des Instruments.

In einem Schritt des erfindungsgemäßen Verfahrens werden Magnetresonanzdaten für eine Abbildung mit einer suszeptibilitaetsbasierten, positiven Kontrastmethode in unmittelbarer Umgebung des Instruments mit dem Magnetresonanztomographen erfasst. Zu Unterabtastung und Kontrastmethode gilt das vorhergehend zum System ausgeführte. Insbesondere ist der Begriff "für eine Abbildung" nicht darauf beschränkt, dass die erfassten Daten für eine vollständige bildliche Darstellung hinreichend sind, sondern nur dass mit einer entsprechenden vollständigen Menge an Daten eine Abbildung möglich wäre.

In einem weiteren Schritt wird eine Orientierung und/oder Position des Instruments mit der Steuerung ermittelt. Dazu wird unter Annahme bzw. Ausnutzung von verschiedenen Eigenschaften des Instruments wie Form und Geometrie das Instrument auf eine geringe Anzahl von Parametern reduziert, die das Bestimmen von Orientierung und/oder Position ermöglicht. Diese Parameter können beispielsweise Mittelpunkts oder Schwerpunktkoordinate sein sowie zwei Winkel zur Ausrichtung und die Länge des Instruments. Denkbar sind auch die Koordinaten der Endpunkte. Verschiedene Möglichkeiten, diese Parameter aus den Magnetresonanzdaten zu erfassen, sind nachfolgend zu den Unteransprüchen beschrieben.

In einem weiteren Schritt wird die Position und/oder Orientierung des Instruments an einen Nutzer durch die Steuerung ausgegeben. Vorzugsweise erfolgt dies in einer bildlichen Darstellung relativ zu dem Patienten auf einem Display an dem Magnetresonanztomographen oder einem abgesetzten Display wie einem Tablet-PC.

Das erfindungsgemäße Verfahren teilt die Vorteile des erfindungsgemäßen Systems.

Weitere Vorteilhafte Ausführungsformen sind zu den Unteransprüchen angegeben.

In einer möglichen Ausführungsform des erfindungsgemäßen Systems ist die Steuerung ausgelegt, beim Ermitteln einer Orientierung und/oder Position des Instruments mindestens m Eingangsdatensätze aus den Magnetresonanzdaten zu erzeugen, wobei n die Anzahl der zu bestimmenden Parameter über eine Position und/oder Orientierung des Instruments ist und wobei vorzugsweise m > n-1.

Dabei entspricht ein Eingangsdatensatz, der beispielsweise durch eine Raumprojektion gewonnen wird, bei einer Radialabtastung einer 1D-Fouriertransformation entlang einer Speiche im k-Raum. Bei einer Spiralabtastung oder anderen Unterabtastung sind entsprechend andere, weniger anschauliche Teil-Bildrekonstruktion als Abbildung zur Gewinnung des Eingangsdatensatzes anzuwenden. In diesem Fall ist der Eingangsdatensatz ein Bilddatensatz, der durch Überführung, Rekonstruktion bzw. Abbildung aus den Magnetresonanzdaten im k-Raum in den Bildraum gewonnen werden.

Die Eingangsdaten können aber auch in Abhängigkeit von den Magnetresonanzdaten generiert werden und dem k-Raum zugeordnet sein. Als Eingangsdatensatz wird dabei eine Mehrzahl oder Ensemble an Eingangsdaten bezeichnet, die in einem gemeinsamen Schritt generiert werden, beispielsweise durch eine Magnetresonanzdatenerfassung.

In einer bevorzugten Ausführungsform des erfindungsgemäßen Systems ist die Steuerung ausgelegt, beim Ermitteln einer Orientierung und/oder Position des Instrumentes unter Verwendung einer radialen k-Raum Abtastung mindestens m Speichen zu erfassen, wobei n die Anzahl der zu bestimmenden Parameter über eine Position und/oder Orientierung des Instruments ist. Durch das Zentralschnitttheorem ist eine geometrische Interpretation einer 1D-fouriertransformierten k-Raum Speiche als Raumprojektion gegeben. Daraus ergibt sich für die Anzahl der mindestens abzutastenden k-Raum Speichen m = n-1. Vorzugsweise wird aber das Gleichungssystem überbestimmt, um Fehler zu minimieren sodass m > n-1 ist. So sind beispielsweise bei unbekannter Länge der Nadel mit Position des Schwerpunkts und zwei zusätzlichen Raumwinkeln vorzugsweise mehr als 5 radiale k-Raum Speichen abzutasten. Zumindest ermöglichen die m Raumprojektionen keine vollständige Rekonstruktion des Bildraumes, da sie einer Unterabtastung des k-Raumes entsprechen. Andere, unter Umständen geometrisch weniger anschauliche, unvollständige Abtastungen des k-Raums, z.B. in Form einer Spirale, sind ebenso denkbar.

Dabei ist m nach oben durch eine vollständige Abtastung des k-Raumes begrenzt. Vorzugsweise ist somit m als Kompromiss zwischen Erfassungszeit und Fehler kleiner als 50%, 20%, 10%, 5% oder 1% der für eine vollständige Abtastung des k-Raums erforderlichen Anzahl an Eingangsdatensätze.

Die Steuerung ist ausgelegt, das Erfassen der Magnetresonanzdaten oder das Erfassen der Magnetresonanzdaten einschließlich Rekonstruktion der m Eingangsdatensätze aus den Magnetresonanzdaten in Abhängigkeit von den n zu ermittelnden Parametern zu modellieren und die n Parameter in einem Optimierungsverfahren derart anzupassen, dass eine Abweichung der modellierten Magnetresonanzdaten bzw. Eingangsdatensätze von den erfassten Magnetresonanzdaten bzw. Eingangsdatensätzen minimiert wird. Mit anderen Worten, die Steuerung nutzt ein sogenanntes Template bzw. Funktion, mit der ausgehend von bekannten Parametern, die die Position des Instruments beschreiben und den bekannten Eigenschaften des Instruments und der Magnetdatenerfassung zunächst die erfassten Magnetresonanzdaten simuliert werden und je nach Ausführungsform auch die daraus rekonstruierten Eingangsdatensätze.

Beispielsweise können die erfassten Magnetresonanzdaten im k-Raum mit einer 3D-Sinc-Funktion angenähert werden. Denkbar ist auch eine Bloch-Simulation der erfassten Magnetresonanzdaten.

Das Erfassen der radialen k-Raum-Speichen und die Raumprojektion kann auch durch eine Radon-Transformation des simulierten Bildraumes modelliert werden, was jedoch einen höheren Rechenaufwand erfordert.

Eine Optimierung ist also sowohl mit den erfassten k-Raum Daten denkbar, als auch eine Optimierung im rekonstruierten Bildraum.

Durch ein Optimierungsverfahren wie beispielsweise LSR (Least Square Root) werden von der Steuerung anhand dieser Funktion die Parameter bestimmt, bei denen die durch die Funktion simulierten Daten, also je nachdem Magnetresonanzdaten oder daraus gewonnenen Eingangsdatensätze, am wenigsten von den Magnetresonanzdaten bzw. aus den Magnetresonanzdaten bestimmten Eingangsdatensätzen abweichen.

Ebenso ist bei einer radialen Abtastung eine Optimierung im Projektionsraum (Sinogramm), also mit den 1D Fouriertransformierten k-Raum Speichen denkbar.

Auf vorteilhafte Weise ermöglichen das erfindungsgemäße System und das darauf ausgeführte Verfahren eine Bestimmung der Orientierung und/oder Position des Instruments mit einer geringen Anzahl schneller Magnetresonanzdatenerfassungen.

In einer denkbaren Ausführungsform des erfindungsgemäßen Verfahrens und Systems weist das System ein trainiertes neuronales Netzwerk auf. Die Steuerung ist ausgelegt, in Abhängigkeit von den erfassten Magnetresonanzdaten Eingangsdaten zu erzeugen und dem trainierten neuronalen Netzwerk zuzuführen. Mit anderen Worten, die Steuerung führt die erfassten Magnetresonanzdaten unverändert oder auch vorbearbeitet dem neuronalen Netzwerk als Eingangsdaten zu, je nachdem, welcher Art das neuronale Netzwerk ist und wie es trainiert wurde. Einige Möglichkeiten sind zu den nachfolgenden Unteransprüchen angegeben.

Das neuronale Netzwerk ermittelt daraus in Abhängigkeit von den erzeugten Eingangsdaten die n Parameter als Ausgangsdaten. Denkbar ist auch, dass das neuronale Netzwerk lediglich ein Vorprodukt liefert, beispielsweise eine Darstellung der Parameter in einem Koordinatensystem, dessen Achsen nicht den einzelnen Parametern entsprechen, sondern Linearkombinationen davon.

Auf vorteilhafte Weise ist das neuronale Netzwerk in der Lage, die Lageparameter des Instruments aus den Abbildungen schneller und zuverlässiger als in einem Optimierungsverfahren zu ermitteln, denn es beruht nicht auf einer mehr oder weniger passenden Modellierung, sondern auf dem Training an realen Daten.

In einer möglichen Ausführungsform des erfindungsgemäßen Systems und Verfahrens ist die Steuerung ausgelegt, als Eingangsdaten Bilddaten mittels einer Rekonstruktion aus den Magnetresonanzdaten zu erzeugen. Mit anderen Worten, die Steuerung erzeugt aus den Magnetresonanzdaten zunächst Bilddaten, beispielsweise durch die Non-Uniform Fast Fourier Transformation, und speist diese als Eingangsdaten in das neuronale Netzwerk ein.

Auf vorteilhafte Weise existieren für Bilddaten eine Vielzahl an effektiven neuronalen Netzwerken, sodass nach einer Transformation in den Bildraum das Bestimmen der Parameter schneller und besser erfolgen kann.

In einer denkbaren Ausführungsform des erfindungsgemäßen Systems ist das neuronale Netzwerk ein 3D Convolutional Netzwerk. Die Steuerung ermittelt dabei die Parameter mit Hilfe eines Fittings eines parametrisierten Modells des Instruments angewendet auf die Ausgabewerte des 3D Convolutional Netzwerks. Für ein lineares Instrument wie eine Nadel ist das Modell ein Ellipsoid, sodass das Fitting einer Hauptkomponentenanalyse entspricht. Ein besonders geeignetes 3D-Convolutionales-Netzwerk ist ein sogenanntes 3D-U-Net.

Auf vorteilhafte Weise ist ein 3D-Convolutionales-Netzwerk für die Analyse von rekonstruierten Bilddaten wie beispielsweise aus einer Non-Uniform Fast Fourier Transformation besonders effektiv und erlaubt zusammen mit dem Fitting an Bilddatensätzen die Parameter zu bestimmen.

Die Erfindung betrifft auch ein Verfahren zum Trainieren des neuronalen Netzwerks. In einem Schritt diese Trainingsverfahrens werden Eingangsdatensätzen für vorbestimmte Positionen des Instruments in einem Untersuchungsobjekt bereitgestellt. Dies können Magnetresonanzdaten oder daraus rekonstruierte Bilddaten sein. Wie diese erzeugt werden können, ist zu den nachfolgenden Unteransprüchen dargelegt. Die Eingangsdatensätze werden an eine Eingangsebene des neuronalen Netzwerks zugeführt. Dies kann durch die Steuerung erfolgen oder auch durch ein dediziertes Trainingssystem außerhalb des Systems. Dies erfolgt vorzugsweise in gleicher Weise, wie in einer Anwendung des Systems und bei Anwendung des Verfahrens zur Lokalisierung des Instruments Magnetresonanzdaten oder aus den Magnetresonanzdaten erzeugte Bilddatensätze zugeführt werden.

In einem weiteren Schritt ermittelt das Trainingssystem oder die Steuerung eine Abweichung zwischen den anhand der vorbestimmten Positionen des Instruments zu erwartenden Werten und den an einer Ausgangsebene des neuronalen Netzwerks ausgegebenen Werten. Die Werte können je nachdem unmittelbar die gesuchten Parameter angeben oder ein Vorprodukt, wie es beispielsweise einem Fitting eines parametrisierten Modells zugeführt wird.

In einem anderen Schritt korrigiert die Steuerung bzw. das Trainingssystem das neuronale Netzwerk in Abhängigkeit von der ermittelten Abweichung. Dies kann beispielsweise mit der sogenannten Backpropagation erreicht werden.

Vorzugsweise werden diese Schritte mit unterschiedlichen Eingangsdatensätzen wiederholt, bis die Abweichungen einen vorbestimmten Schwellwert unterschreiten.

In einer möglichen Ausführungsform des erfindungsgemäßen Verfahrens zum Trainieren des neuronalen Netzwerks weist das Verfahren in dem Schritt Bereitstellen den Schritt auf, das Instrument in einem Untersuchungsobjekt in einer vorbestimmten Position anzuordnen. Vorzugsweise handelt es sich bei dem Untersuchungsobjekt um ein Phantom, das vergleichbare Abbildungseigenschaften zu einem menschlichen Körper aufweist, insbesondere in Bezug auf die suszeptibilitaetsbasierten, positiven Kontrastmethode. Im einfachsten Fall kann es sich um einen mit Wasser gefüllten Behälter handeln, um ein wasserhaltiges Gel oder tierisches Gewebe.

In einem weiteren Schritt werden Magnetresonanzdaten für eine Abbildung mit einer suszeptibilitätsbasierten, positiven Kontrastmethode in unmittelbarer Umgebung des Instruments mit dem Magnetresonanztomographen gewonnen, wobei die Abtastung des k-Raums eine Unterabtastung ist. In einem weiteren Schritt werden die erfassten Magnetresonanzdaten mithilfe einer Bildrekonstruktion in den Bildraum überführt.

Zum Erfassen der Magnetresonanzdaten und dem Erzeugen der Bilddatensätze gilt das bereits zum Erfassen im Rahmen des erfindungsgemäßen Verfahrens zur Lokalisierung dargelegte. Die so erzeugten Daten für das Training sollen den während des Verfahrens zur Lokalisierung bis auf die jeweils unterschiedlichen Positionen und/oder Orientierungen so weit wie möglich ähneln, um ein effektives Trainieren zu gewährleisten.

Auf vorteilhafte Weise ermöglicht das Erfassen von Beispielhaften Daten an einem Phantom möglichst realistische Eingabedaten für ein Training eines neuronalen Netzwerks.

In einer denkbaren Ausführungsform des erfindungsgemäßen Verfahrens zum Trainieren des neuronalen Netzwerks werden in dem Schritt Bereitstellen von Magnetresonanzdaten für eine Abbildung mit einer suszeptibilitätsbasierten, positiven Kontrastmethode simuliert. Beispielsweise können die erfassten Magnetresonanzdaten im k-Raum mit einer 3D-Sinc-Funktion angenähert werden. Denkbar ist auch eine Bloch-Simulation der erfassten Magnetresonanzdaten.

In einem weiteren Schritt werden die erfassten Magnetresonanzdaten mithilfe einer Bildrekonstruktion, wie bereits zum System beschrieben, in den Bildraum überführt.

Auf vorteilhafte Weise ermöglicht eine Simulation des Erfassens der Magnetresonanzdaten und der nachfolgenden Bildrekonstruktion eine effektive und schnelle Möglichkeit, eine Vielzahl an Trainingsdaten für das Training des neuronalen Netzwerks zu generieren.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung einer Ausführungsform eines erfindungsgemäßen Magnetresonanztomographen zur Ausführung des erfindungsgemäßen Verfahrens;
- Fig. 2: einen schematischen Ablaufplan einer Ausführungsform des erfindungsgemäßen Verfahrens;
- Fig. 3: einen schematischen Ablaufplan einer Ausführungsform des erfindungsgemäßen Verfahrens;
- Fig. 4: eine schematische Darstellung eines in dem erfindungsgemäßen Verfahren genutzten unterabgetasteten Abtastschemas;
- Fig. 5: eine schematische Darstellung von beispielhafte in dem Verfahren angewendeten Raumprojektionen;
- Fig. 6: einen schematischen Ablaufplan einer Ausführungsform eines erfindungsgemäßen Verfahrens zum Trainieren eines neuronalen Netzwerks.

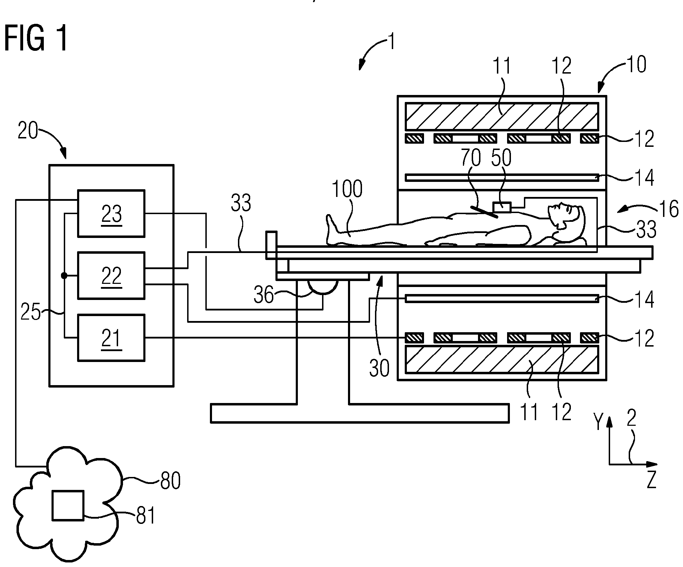

Fig. 1 zeigt eine schematische Darstellung einer Ausführungsform eines erfindungsgemäßen Magnetresonanztomographen 1 zur Ausführung des erfindungsgemäßen Verfahrens.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt.

Eine Patientenliege 30 ist in dem Patiententunnel 16 von der Verfahreinheit 36 bewegbar.

Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben. Im Folgenden bezeichnet der Begriff Sendeantenne eine Antenne, über die das Hochfrequenzsignal zur Anregung der Kernspins ausgestrahlt wird. Dies kann die Körperspule 14 sein, aber auch eine Lokalspule 50 mit Sendefunktion.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungssignale können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22.

Auf dem Patienten 100 ist als eine Lokalspule 50 angeordnet, die über eine Anschlussleitung 33 mit der Hochfrequenzeinheit 22 und deren Empfänger verbunden ist. Denkbar ist es aber auch, dass die Körperspule 14 eine Empfangsantenne im Sinne der Erfindung ist.

Ein Instrument 70, beispielsweise eine Biopsienadel, kann in den Patienten 100 eingeführt werden. Das Instrument 70 ist vorzugsweise metallisch. Es ist auch denkbar, dass das Instrument 70 einen Marker aufweist, der von dem Magnetresonanztomographen 1 erfassbare Magnetresonanzsignale erzeugt.

Der Magnetresonanztomograph 1 kann auch über eine Signalverbindung mit einer externen Signalverarbeitungsressource wie einer Cloud 80 als Teil des Systems verbunden sein, in der Teile des erfindungsgemäßen Verfahrens ausgeführt werden. Die Cloud 80 kann auch das nachfolgend beschriebene neuronale Netzwerk 81 aufweisen.

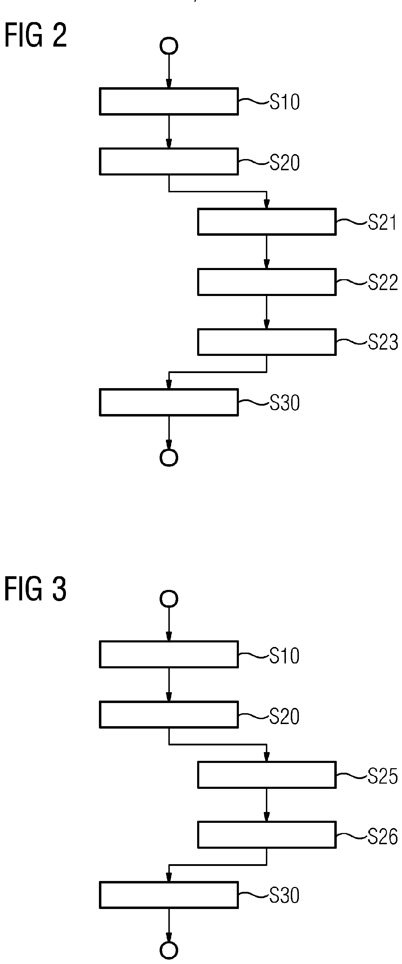

Fig. 2 zeigt einen schematischen Ablaufplan einer Ausführungsform des erfindungsgemäßen Verfahrens.

Das erfindungsgemäße Verfahren wird auf einem erfindungsgemäßen Magnetresonanztomographen 1 ausgeführt.

In einem Schritt S10 werden von dem erfindungsgemäßen Magnetresonanztomographen 1 Magnetresonanzdaten zur Abbildung des Instruments 70 erfasst. Die erfassten Magnetresonanzdaten sind dabei grundsätzlich für eine Abbildung des Instruments 70 geeignet, aber nicht vollständig in dem Sinne, dass diese z.B. aufgrund von Artefakten für eine Diagnose nutzbar wären. Vielmehr entspricht die Magnetresonanzdatenerfassung einer Unterabtastung, d.h. der k-Raum wird nicht vollständig in einem kartesischen Gitter erfasst, sondern beispielsweise wie in Fig. 3 dargestellt entlang einer Mehrzahl linearer Trajektorien durch das Zentrum des k-Raums. Auch sind andere unterabgetastete Trajektorien wie beispielsweise eine Spirale denkbar. Allen diesen Abtastformen ist aber gemeinsam, dass sie nicht hinreichend für eine vollständige bildliche Darstellung durch eine übliche Bildrekonstruktion sind. Vielmehr ist es erforderlich, gewisse Annahmen über das Instrument 70 zu treffen, die das Instrument charakterisieren und deren Bestimmung es erlaubt, eine Lage und/oder Position des Instruments mit einer geringen Anzahl an Parametern zu definieren. Eine Hohlnadel ist beispielsweise durch eine Länge und die Position des Schwerpunktes und eine Orientierung im Raum bestimmt.

Diese Parameter wiederum können mit einer geringen Anzahl an unterabgetasteten Magnetresonanzdatenerfassungen ermittelt werden. Entsprechend einem linearen Gleichungssystem mit n Unbekannten können bei m = n mit m linear unabhängigen Gleichungen die n Unbekannten bestimmt werden. Bei mehr Gleichungen ist das System überbestimmt und die zusätzliche Information kann genutzt werden, um beispielsweise durch eine Optimierungsverfahren die Fehler zu minimieren. Die erforderliche Anzahl an Daten ist dennoch wesentlich geringer als bei einer vollständigen Abbildung und erlaubt ein Erfassen der Lage und oder Position des Instruments 70 mit weniger Magnetresonanzdatenerfassungen in geringerer Zeit.

Vorzugsweise erfolgt dabei die Magnetresonanzdatenerfassung mit einer sogenannten White-Marker-Sequenz. Dabei ist eine Sequenz zu verstehen, die das Instrument 70 oder die unmittelbare Umgebung des Instruments 70 durch ein erfassbares Magnetresonanzsignal auszeichnet, während in weiter beabstandeten Regionen des Untersuchungsobjektes bzw. Patienten 100 ein erfassbares Magnetresonanzsignal unterdrückt wird. Dies kann beispielsweise durch einen Rephasierungsgradienten erzielt werden, der die durch eine Suzeptibilität des Metalls um das Instrument 70 verursachte Feldveränderung kompensiert, während er in weiteren Abstand von dem Suzeptibilitätseffekt nicht betroffene Spins dephasiert und so diese kein Signal und einen dunklen Hintergrund liefern. Dies wurde beispielsweise im Rahmen einer Gradienten-Echo-Sequenz erfolgreich getestet. Denkbar sind auch Markierungen an dem Instrument 70, die als resonante Schwingkreise selbst ein Signal liefern oder auf andere Weise die Spins in der Umgebung beeinflussen.

In einem weiteren Schritt S20 wird von der Steuerung 23 des Magnetresonanztomographen 1 eine Orientierung und/oder Position des Instruments 70 ermittelt. Die Steuerung kann aber auch ein dedizierter Rechner oder eine Rechenressource in einer Cloud sein, die über ein Netzwerk oder einen Server Zugriff auf die in Schritt S10 erfassten Magnetresonanzdaten erhält. Das Ermitteln der Orientierung und/oder Position des Instruments 70 beruht im Wesentlichen darauf, die bereits angeführten Parameter, die die Lage und/oder Position des Instruments 70 charakterisieren, zu bestimmen, indem die Magnetresonanzdatenerfassung in Abhängigkeit von den Parametern simuliert wird und die Parameter variiert werden, bis die erfassten Magnetresonanzdaten mit den simulierten Magnetresonanzdaten am besten übereinstimmen. Unterschiedliche Ausführungsformen zum Bestimmen der Parameter werden nachfolgend beschrieben.

In einem Schritt S30 werden anschließend die Position und/oder Orientierung des Instruments 70 an einen Nutzer ausgegeben. Vorzugsweise erfolgt dabei die Ausgabe in graphischer Form, beispielsweise indem die Lage des Instruments 70 relativ zu dem Patienten 100 dargestellt wird. Dies kann beispielsweise in Form eines Schnittbildes erfolgen, in dem das Instrument 70 und der Patient 100 dargestellt sind. Vorzugsweise erfolgt dabei die Wahl der Schnittebene in Abhängigkeit von einer Position oder Blickrichtung des Benutzers auf den Patienten 100. Denkbar ist es dabei auch, dass die Darstellung als Virtual Reality für den Nutzer gerendert wird.

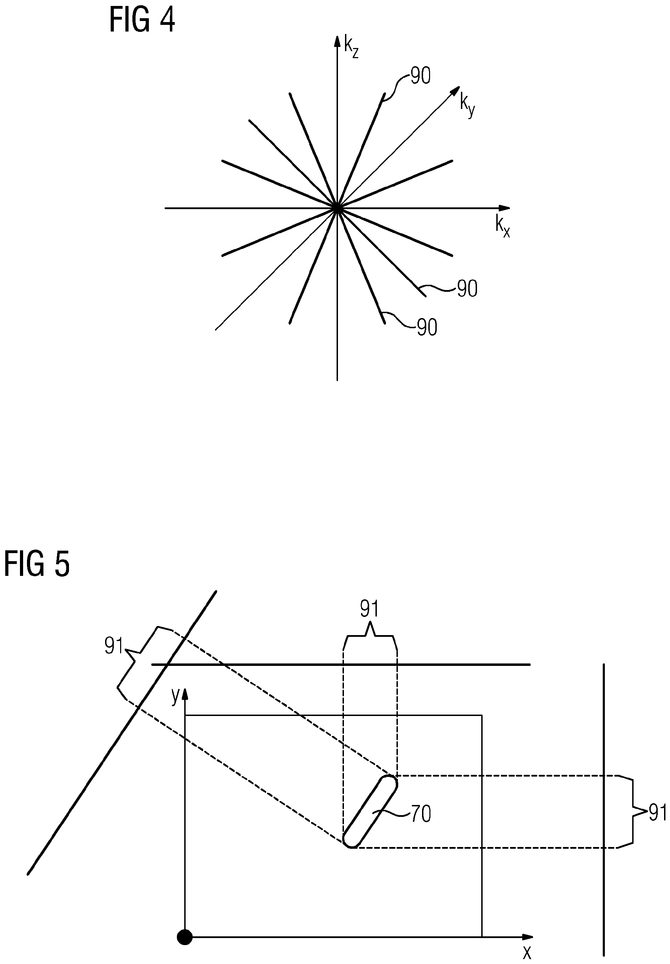

In einer denkbaren Ausführungsform des erfindungsgemäßen Verfahrens werden in dem Schritt S20 des Ermittelns einer Orientierung und/oder Position des Instruments 70 von der Steuerung zunächst in einem Schritt S21 m Eingangsdatensätzen aus den Magnetresonanzdaten erzeugt. Für die Radialabtastung, wie sie in Fig. 4 dargestellt durch die linearen Trajektorien durch den Ursprung des k-Raums dargestellt ist, lässt sich ein eine Raumprojektion mit einer eindimensionalen Fouriertransformation entlang der auch als "Spoke" bezeichneten Radialtrajektorie 90 erzeugen. In Fig. 5 sind schematisch drei Projektionen 91 des Instruments 70 bzw. der von ihm erzeugten White-Contrast-Bilddaten schematisch dargestellt. Die Anzahl der Raumprojektionen 91 muss dabei mindestens so große gewählt werden, dass aus den Projektionen mindestens so viele Daten entnommen werden können, wie an Parametern für das Instrument 70 zu ermitteln sind. Es ergibt sich also ein Gleichungssystem, aus dem die Parameter bestimmt werden können. Vorzugsweise ist die Anzahl der Raumprojektionen 91 jedoch größer, sodass das Gleichungssystem überbestimmt ist und durch ein Optimierungsverfahren die Fehler in nachfolgenden Schritten minimiert werden können.

In einem weiteren Schritt S22 werden von der Steuerung das Erfassen der Magnetresonanzdaten in Schritt S10 und die m Raumprojektionen 91 aus den Magnetresonanzdaten in Schritt S21 in Abhängigkeit von den n zu ermittelnden Parametern modelliert. Beispielsweise werden die Parameter als Eingangsdaten genutzt, um daraus die Position und Orientierung des Instruments 70 zu bestimmen und bei dieser Position des Instruments 70 zu erwartende Magnetresonanzdaten errechnet werden. Die Magnetresonanzdaten können beispielsweise durch eine Sinc-Funktion für die Kernspins in der Umgebung des Instruments angenähert werden. Denkbar sind aber auch komplexere Annäherungen wie durch Bloch-Funktionen, wenn entsprechende Rechenkapazitäten verfügbar sind.

In einem Schritt S23 werden nun von der Steuerung die n Parameter in einem Optimierungsverfahren so angepasst, dass eine Abweichung der modellierten Projektionen von den aus den erfassten Magnetresonanzdaten erzeugten Projektionen minimiert wird. Denkbar ist beispielsweise ein LSR-Verfahren, bei dem eine Abweichung zwischen den ermittelten Projektionen aus den Magnetresonanzdaten und den simulierten Projektionen durch Variation der Parameter minimiert wird.

In einer in Fig. 3 dargestellten anderen möglichen Ausführungsform des erfindungsgemäßen Verfahrens weist das System ein trainiertes neuronales Netzwerk 81 auf. Das neuronale Netzwerk kann wie die Steuerung 23 Teil des Magnetresonanztomographen 1 bzw. der Steuerung 23 sein, aber auch einer externen und/oder zentralen Ressource wie ein Cloud-Server. Möglichkeiten zum Training des neuronalen Netzwerkes sind nachfolgend zu den entsprechenden Verfahren näher erläutert.

In einem Schritt S25 werden von der Steuerung in Abhängigkeit von den erfassten Magnetresonanzdaten Eingangsdaten für das neuronale Netzwerk erzeugt. Dabei ist es denkbar, dass die Eingangsdaten unmittelbar aus den Magnetresonanzdaten abgeleitet werden, aber auch, dass zunächst eine Bildrekonstruktion aus dem unterabgetasteten k-Raum ausgeführt wird. Denkbar ist bei einer radialen Abtastung des k-Raums auch eine Ueberfuehrung in den Projektionsraum (Sinogramm). Durch die Bildrekonstruktion werden die Daten in den Bildraum überführt. Da eine Vielzahl von neuronalen Netzwerken für die Verarbeitung von Bilddaten mit ihrer Lokalität der Daten existieren und optimiert wurden, lassen sich auf Basis der Bilddatensätze besonders effektive Systeme bereitstellen. Ein beispielhaftes neuronales Netzwerk 81 kann 3D-Convolutionales-Netzwerk sein, insbesondere ein 3D-U-Network sein.

In einem Schritt S26 werden von der Steuerung dem trainierten neuronalen Netzwerk die Eingangsdaten zugeführt. Das trainierte neuronale Netzwerk ermittelt die n Parameter in Abhängigkeit von den erzeugten Eingangsdaten.

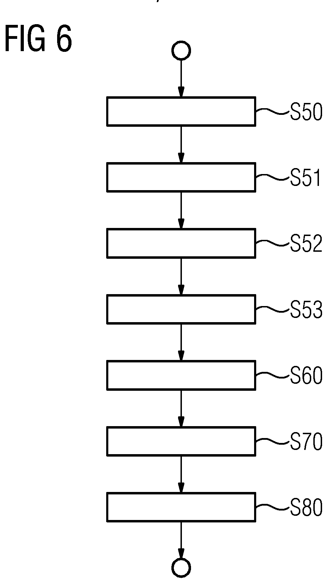

Das neuronale Netzwerk wird gemäß eines erfindungsgemäßen Trainingsverfahrens für das Ermitteln der Parameter trainiert, das schematisch in seinem Ablauf in Fig. 6 dargestellt ist.

In einem Schritt S50 werden Eingangsdaten für vorbestimmte Positionen des Instruments in einem Untersuchungsobjekt bereitgestellt.

Dazu ist es denkbar, dass das Instrument 70 in einem Schritt S51 in einem Untersuchungsobjekt in einer vorbestimmten Position angeordnet wird. Dazu kann als Untersuchungsobjekt alles verwendet werden, das zu einem Patienten 100 vergleichbare Eigenschaften bezüglich der Magnetresonanztomographie aufweist, beispielsweise ein mit Wasser befülltes Phantom, ein Gelkörper oder auch totes tierisches Gewebe.

In einem Schritt S52 werden von dem Magnetresonanztomographen 1 Magnetresonanzdaten für eine Abbildung mit einer suszeptibilitätsbasierten, positiven Kontrastmethode in unmittelbarer Umgebung des Instruments 70 erfasst. Vorzugsweise kommt hier eine Bilderfassungssequzenz zum Einsatz, die bereits für Schritt S10 beim Erfassen der Magnetresonanzdaten für die produktive Anwendung des erfindungsgemäßen Verfahrens beschrieben wurde. Insbesondere ist die Abtastung des k-Raums eine Unterabtastung. Vorzugsweise werden Magnetresonanzdaten für eine Vielzahl an Positionen des Instruments 70 in dem Untersuchungsobjekt erfasst.

In einem Schritt S53 werden die Magnetresonanzdaten zu Eingangsdaten vorverarbeitet, beispielsweise im Falle einer radialen Abtastung des k-Raums die Raumprojektionen 91 aus den Magnetresonanzdaten erzeugt oder die Magnetresonanzdaten durch eine Bildrekonstruktion in den Bildraum ueberfuehrt.

Auch hier gilt wieder, dass das Erzeugen der Bilddatensätze bzw. Raumprojektionen 91 in gleicher Weise erfolgt, wie es auch in dem erfindungsgemäßen Verfahren zur 3D-Lokalisierung genutzt wurde und dort bereits beschrieben wurde.

In einem Schritt S60 werden die Eingangsdaten einer Eingangsebene des neuronalen Netzwerks zugeführt. Dies kann bei einem Training im System bzw. Magnetresonanztomographen 1 durch die Steuerung 23 erfolgen, aber auch bei einem externen Training in einem separaten Trainingssystem durch eine Trainingssteuerung.

In einem Schritt S70 wird eine Abweichung zwischen anhand der vorbestimmten Positionen des Instruments 70 beim Erzeugen der Magnetresonanzdaten zu erwartenden Ausgabewerten und den an einer Ausgangsebene des neuronalen Netzwerks ausgegebenen Werten ermittelt.

Anschließend wird in einem Schritt S80 das neuronale Netzwerk in Abhängigkeit von der ermittelten Abweichung korrigiert. Dies kann beispielsweise über Backpropagation erfolgen.

Anschließend werden die Schritte S50 bis S80 mit veränderten Eingangsdaten wiederholt, bis die Abweichung unter ein vorbestimmtes Maximum fällt.

Es ist aber auch denkbar, dass die Magnetresonanzdaten für das Training in Schritt S50 nicht an einem Phantom real erfasst werden, sondern wie bereits zur Modellierung dargelegt für unterschiedliche Positionen und/oder Orientierungen des Instruments physikalisch simuliert werden, beispielsweise durch Annähern der Reaktion der Kernspins auf die Erfassungssequenz durch eine Sinc-Funktion oder durch eine Bloch-Simulation. Auch hier ist die Abtastung des k-Raums wieder eine Abtastung des k-Raums in Form einer Unterabtastung.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. System aus einem Magnetresonanztomographen (1) und einer Steuerung (23) zur 3D-Lokalisierung eines Instruments (70) mittels des Magnetresonanztomographen (1),
wobei der Magnetresonanztomograph (1) ausgelegt ist, Magnetresonanzdaten für eine Abbildung mit einer suszeptibilitätsbasierten, positiven Kontrastmethode in unmittelbarer Umgebung des Instruments (70) zu erfassen, wobei die Abtastung des k-Raums eine Unterabtastung ist;
die Steuerung (23) ausgelegt ist, mit den Magnetresonanzdaten eine Orientierung und/oder Position des Instruments (70) zu ermitteln;
und die Steuerung (23) ausgelegt ist, die Position und/oder Orientierung des Instruments (70) an einen Benutzer auszugeben.

2. System nach Anspruch 1, wobei die Steuerung (23) ausgelegt ist, beim Ermitteln einer Orientierung und/oder Position des Instruments (70) mindestens m Eingangsdatensätze aus den Magnetresonanzdaten zu erzeugen, wobei n die Anzahl der zu bestimmenden Parameter über eine Position und/oder Orientierung des Instruments (70) ist und wobei m ≥ n-1;
wobei die Steuerung (23) ausgelegt ist, das Erfassen der Magnetresonanzdaten und die m Eingangsdatensätze aus den Magnetresonanzdaten in Abhängigkeit von den n zu ermittelnden Parametern zu modellieren und die n Parameter in einem Optimierungsverfahren derart anzupassen, dass eine Abweichung der modellierten Eingangsdatensätze aus den erfassten Magnetresonanzdaten erzeugten Eingangsdatensätzen minimiert wird.

3. System nach Anspruch 2, wobei die Steuerung (23) ausgelegt ist, die Magnetresonanzdaten mit radialen Trajektorien zu erfassen.

4. System nach Anspruch 1, wobei das System ein trainiertes neuronales Netzwerk (81) aufweist, wobei die Steuerung (23) ausgelegt ist, in Abhängigkeit von den erfassten Magnetresonanzdaten Eingangsdaten zu erzeugen und dem trainierten neuronalen Netzwerk (81) zuzuführen, wobei das neuronale Netzwerk (81) ausgelegt ist, die n Parameter in Abhängigkeit von den erzeugten Eingangsdaten zu ermitteln.

5. System nach Anspruch 4, wobei die Steuerung (23) ausgelegt ist, als Eingangsdaten eine Abbildung mittels einer Bildrekonstruktion aus den Magnetresonanzdaten zu erzeugen.

6. System mach Anspruch 5, wobei das neuronale Netzwerk (81) ein 3D-Convolutionales Netzwerk ist und das System ausgelegt ist, die Parameter mittels eines Fittings eines parametrisierten Modells an die Ausgabewerte des 3D-Convolutionales Netzwerks (81) zu ermitteln.

7. Verfahren zur 3D-Lokalisierung eines Instruments (70) mittels eines Systems aus einem Magnetresonanztomographen (1) und einer Steuerung (23), wobei das Verfahren die Schritte aufweist:
(S10) Erfassen von Magnetresonanzdaten für eine Abbildung mit einer suszeptibilitätsbasierten, positiven Kontrastmethode in unmittelbarer Umgebung des Instruments (70) mit dem Magnetresonanztomographen (1), wobei die Abtastung des k-Raums eine Unterabtastung ist;
(S20) Ermitteln einer Orientierung und/oder Position des Instruments (70) mit der Steuerung (23);
(S30) Ausgeben der Position und/oder Orientierung des Instruments (70) an einen Benutzer durch die Steuerung (23).

8. Verfahren nach Anspruch 7, wobei in dem Schritt (S20) des Ermittelns einer Orientierung und/oder Position des Instruments (70) von der Steuerung (23) in einem Schritt (S21) m Eingangsdatensätzen aus den Magnetresonanzdaten erzeugt werden, wobei n die Anzahl der zu bestimmenden Parameter über eine Position und/oder Orientierung des Instruments (70) ist und wobei m ≥ n-1;
wobei in einem Schritt (S22) Modellieren das Erfassen der Magnetresonanzdaten in Schritt (S10) und die m Eingangsdatensätze aus den Magnetresonanzdaten in Schritt (S21) in Abhängigkeit von den n zu ermittelnden Parametern von der Steuerung (23) modelliert werden und in einem Schritt (S23) die n Parameter in einem Optimierungsverfahren von der Steuerung (23) so angepasst werden, dass eine Abweichung der modellierten Eingangsdatensätzen von den aus den erfassten Magnetresonanzdaten erzeugten Eingangsdatensätzen minimiert wird.

9. Verfahren nach Anspruch 8, wobei die Magnetresonanzdaten mit radialen Trajektorien erfasst werden.

10. Verfahren nach Anspruch 7, wobei das System ein neuronales Netzwerk (81) aufweist und in einem Schritt (S25) in Abhängigkeit von den erfassten Magnetresonanzdaten von der Steuerung (23) Eingangsdaten erzeugt und Schritt (S26) dem trainierten neuronalen Netzwerk (81) zugeführt werden, welches die n Parameter in Abhängigkeit von den erzeugten Eingangsdaten ermittelt.

11. Verfahren nach Anspruch 10, wobei in dem Schritt (S25) als Eingangsdaten eine Abbildung von der Steuerung (23) mittels einer Bildrekonstruktion aus den Magnetresonanzdaten erzeugt werden.

12. Verfahren nach Anspruch 11, wobei das neuronale Netzwerk (81) ein 3D-Convolutionales-Netzwerk, insbesondere ein 3D-U-Netzwerk ist und die Parameter mittels eines Fittings eines parametrisierten Modells des Instruments (70) angewendet auf die Ausgabewerte des 3D-Convolutionalen-Netzwerks ermittelt werden.

13. Verfahren zum Trainieren eines neuronalen Netzwerks (81) nach Anspruch 4, wobei das Verfahren die Schritte aufweist: Bereitstellen (S50) von Eingangsdatensätzen für vorbestimmte Positionen des Instruments (70) in einem Untersuchungsobjekt; Zuführen (S60) der Eingangsdatensätze an eine Eingangsebene des neuronalen Netzwerks (81);
Ermitteln (S70) einer Abweichung zwischen anhand der vorbestimmten Positionen des Instruments (70) zu erwartenden Ausgabewerten und den an einer Ausgangsebene des neuronalen Netzwerks (81) ausgegebenen Werten;
Korrigieren (S80) des neuronalen Netzwerks (80) in Abhängigkeit von der ermittelten Abweichung;
Wiederholen der vorhergehenden Schritte mit veränderten Eingangsdatensätzen.

14. Verfahren nach Anspruch 13, wobei in dem Schritt Bereitstellen (S50)
das Instrument (70) in einem Untersuchungsobjekt in einer vorbestimmten Position angeordnet wird;
Erfassen von Magnetresonanzdaten für eine Abbildung mit einer suszeptibilitätsbasierten, positiven Kontrastmethode in unmittelbarer Umgebung des Instruments mit dem Magnetresonanztomographen (1), wobei die Abtastung des k-Raums eine Unterabtastung ist;
Erzeugen von Eingangsdatensätzen aus den erfassten Magnetresonanzdaten.

15. Verfahren nach Anspruch 12, wobei in dem Schritt Bereitstellen (S50)
Magnetresonanzdaten für eine Abbildung mit einer suszeptibilitätsbasierten, positiven Kontrastmethode in unmittelbarer Umgebung des Instruments (70) mit dem Magnetresonanztomographen (1) für vorbestimmte Positionen des Instruments (70) simuliert werden, wobei die Abtastung des k-Raums eine Unterabtastung ist;
und Erzeugen von Eingangsdatensätzen aus den simulierten Magnetresonanzdaten.
